# EUROPÄISCHE PATENTSCHRIFT

(11) **EP 1 335 997 B1**
(45) Veröffentlichungstag und Bekanntmachung des Hinweises auf die Patenterteilung: **29.06.2005**
(21) Anmeldenummer: 01983565.1
(22) Anmeldetag: 25.10.2001
(51) Int. Cl.: C30B 25/14, C30B 25/16, C30B 25/10, C23C 16/458

(54) **VERFAHREN UND VORRICHTUNG ZUR TEMPERATURSTEUERUNG DER OBERFLÄCHENTEMPERATUREN VON SUBSTRATEN IN EINEM CVD-REAKTOR**
METHOD AND DEVICE FOR CONTROLLING THE SURFACE TEMPERATURES OF SUBSTRATES IN A CHEMICAL VAPOUR DEPOSITION REACTOR
PROCEDE ET DISPOSITIF DE COMMANDE DES TEMPERATURES DE SURFACE DE SUBSTRATS DANS UN REACTEUR DE DEPOT CHIMIQUE EN PHASE VAPEUR

(30) Priorität: 11.11.2000 DE 10056029
(43) Veröffentlichungstag der Anmeldung: 20.08.2003
(73) Patentinhaber: Aixtron AG, 52072 Aachen (DE)
(72) Erfinder: KÄPPELER, Johannes, 52146 Würselen (DE)
(74) Vertreter: Grundmann, Dirk, Dr.
(86) Internationale Anmeldenummer: PCT/EP2001/012310
(87) Internationale Veröffentlichungsnummer: WO 2002/038840

(56) Entgegenhaltungen:
- WO-A-90/13687
- WO-A-98/51843
- DE-A- 19 855 637
- US-A- 5 788 777

## Beschreibung

Die Erfindung betrifft ein Verfahren und eine Vorrichtung zur Temperatursteuerung der Oberflächentemperaturen von in einer Prozesskammer eines CVD-Reaktors auf von einem Substrathalter-Träger auf dynamischen Gaspolstern getragenen Substrathaltern liegenden Substraten.

Die Erfindung betrifft ferner einen CVD-Reaktor mit einer Vielzahl auf einem Substrathalter-Träger auf dynamischen Gaspolstern getragenen Substrathaltern.

Ein gattungsgemäßer CVD-Reaktor bzw. ein gattungsgemäßes Verfahren zeigt die DE 198 55 637 A1.

Bei bekannten CVD-Reaktoren, wie sie beispielsweise zum Abscheiden von III-V-Halbleiterschichten auf III-V-Substraten verwendet werden, liegen die Substrate auf Substrathaltern, welche die Form von Kreiszylinder-Scheiben haben. Diese Substrathalter liegen in satellitenartiger Anordnung in auf einem Substrathalter-Träger angeordneten Aussparungen und werden dort mittels eines Gaspolsters drehgelagert. Bei einem derartigen CVD-Reaktor können sich nicht nur die Substrathalter relativ zum Substrathalter-Träger drehen. Es ist auch vorgesehen, dass sich der Substrathalter-Träger selbst um seine Achse dreht.

Der Substrathalter-Träger besteht ebenso wie die einzelnen Substrathalter aus Grafit. Fertigungsbedingt besitzt das Grafit Inhomogenitäten. Des Weiteren weichen die Höhen der einzelnen Gaspolster voneinander ab. Der Substrathalter-Träger wird von unten mittels einer Hochfrequenz-Heizung beheizt. Die Inhomogenitäten und die unterschiedlichen Luftpolsterhöhen haben abweichende Wärmetransporte zu den Substraten zur Folge, was sich in unterschiedlichen Substrat-Oberflächentemperaturen widerspiegelt. Die Substrat-Oberflächentemperaturen der in einer Prozesskammer liegenden Substrate können um mehrere Grad voneinander abweichen. Verschiedene Substrattypen, welche sich z. B. in der Dicke oder der Rückseitenpolierung unterscheiden, können zu einem unterschiedlichen Wärmeübertrag vom Substrathalter zum Substrat führen und damit die Substrattemperatur beeinflussen. Durch geeignete Kontrolle und Auswahl der Parameter wie z. B. Materialien, Gewicht, Dicken, etc, können die Abweichungen der Temperaturen der einzelnen Substrate auf ca. 1-2 Grad minimiert werden.

Für einige Anwendungen, welche spezielle Anforderungen an Schichtdicke und -zusammensetzung fordern, ist es erforderlich, die Temperaturabweichungen unter einem Grad bevorzugt unter einem halben Grad zu halten. Weiterhin ist es vorteilhaft großere Temperaturschwankungen zwischen den Substraten zum Beispiel durch ungewollte (oder gewollte) Verwendung von Substrathaltern oder Substraten unterschiedlicher Dicke, durch eine automatische Regelung zu erkennen und auszugleichen, um damit die Prozesskontrolle zu erleichtern.

Der Erfindung liegt daher die Aufgabe zugrunde, Maßnahmen vorzuschlagen, um die Temperaturabweichung zu verringern bzw. anzugleichen.

Gelöst wird die Aufgabe durch die in den Ansprüchen angegebene Erfindung. Der Anspruch 1 schlägt zunächst und im Wesentlichen vor, dass von den insbesondere optisch gemessenen Temperaturen Mittelwerte gebildet werden und durch Variation der einzelgesteuerten, die Gaspolster erzeugenden Gasströme die Höhen der Gaspolster so eingeregelt werden, dass die Abweichungen der gemessenen Oberflächentemperaturen vom Mittelwert innerhalb eines vorgegebenen Temperaturfensters liegen. Es ist bevorzugt vorgesehen, dass das Temperaturfenster etwa ein Grad oder ein halbes Grad beträgt. Ferner kann vorgesehen sein, dass der Mittelwert dem einzustellenden Temperatur-Sollwert entspricht. Dies hat den Vorteil, dass nur minimale Abweichungen nach oben und nach unten möglich sind. In einer Weiterbildung der Erfindung ist vorgesehen, dass die Substrathalter vom Gasstrom drehangetrieben werden. Ferner kann die Drehzahl überwacht werden. Hierzu kann ein Drehzahlmessorgan vorgesehen sein, welches die Drehzahlen der einzelnen Substrathalter bestimmt. Die Drehzahlermittlung kann nacheinander durch ein einziges Drehzahlmessorgan erfolgen, an welchem sich die einzelnen Substrathalter zufolge der Drehung des Substrathalter-Trägers vorbeibewegen. Die Drehzahl der Substrathalter soll einen Minimalwert nicht unterschreiten, damit insgesamt ein über das gesamte Substrat homogenes Kristallwachstum erfolgt.
Die Temperaturmessung kann durch eine Öffnung in der Prozesskammerdecke erfolgen. Hierzu kann ein optisches Temperaturmessorgan, beispielsweise ein Pyrometer vorgesehen sein, welches von oben durch die besagte Öffnung auf den Substrathalter-Träger gerichtet ist. Als Messorgan können solche Vorrichtungen verwendet werden, die temperaturabhängige Schichteigenschaften ermitteln können, um damit direkt oder indirekt die Temperatur zu bestimmen. Beispielsweise kann das temperaturabhängige Schichtwachstum durch Messung der Schichtdicke mittels Reflektionsmessungen bestimmt werden. Zufolge der Drehung des Substrathalter-Trägers wandern die einzelnen Substrathalter nacheinander an dem Temperaturmessorgan vorbei, so dass nacheinander die Temperaturen der einzelnen Substrate gemessen werden kann. Am Substrathalter-Träger kann eine geeignete Markierung vorgesehen sein, die durch einen geeigneten Sensor abfragbar ist, um die Winkelstellung des Substrathalters mit den vom Temperaturmessorgan gelieferten Messwerten zu synchronisieren. Bevorzugt erfolgt das Aufheizen der Prozesskammer zunächst ohne eine Regelung der Gasströme. Die Gasströme werden auf vorgegebenen Werten gehalten.
Diese können Erfahrungswerte vorhergehender Beschichtungsschritte sein, bei denen sich möglichst geringe Temperaturunterschiede eingestellt haben. Erst wenn die der Mittelwert der gemessenen Substrattemperaturen eine insbesondere stabilen Sollwert erreicht hat, welcher insbesondere der Solltemperatur entsprechen kann, beginnt die Regelung der Oberflächentemperaturen durch Variation der Gaspolsterhöhe.

Die Erfindung betrifft ferner einen CVD-Reaktor mit einer Vielzahl auf einem Substrathalter-Träger von dynamischen Gaspolstern getragenen Substrathaltern.

Der aus dem Stand der Technik bekannte CVD-Reaktor wird erfindungsgemäß durch eine mindestens ein Temperaturmessorgan aufweisende Messvorrichtung zum Bestimmen der Oberflächentemperaturen aller auf den Substrathaltern aufliegenden Substraten weitergebildet, wobei ein Temperaturregelorgan und jedem Substrathalter individuell zugeordnete Gasmassensteuereinrichtungen vorgesehen sind, welche vom Temperaturregelorgan derart angesteuert werden, dass durch Variation der Gaspolsterhöhen die Substrattemperaturen in einem vorgegebenen Temperaturfenster gehalten werden. Auch hier ist es von Vorteil, wenn die Substrathalter vom Gasstrom drehangetrieben werden. Auch kann der Substrathalter-Träger drehangetrieben sein. Es ist dann bevorzugt ein einziges, oberhalb einer Öffnung der Prozesskammerdecke angeordnetes Temperaturmessorgan vorgesehen. Am Außenumfang des Substrathalter-Trägers kann ein Drehzahlmessorgan vorgesehen sein, welches optisch durch Fenster des Substrathalter-Trägers mit Index-Markierungen versehene Umfangsflächen der Substrathalter abtastet. Ist nur ein einziges Temperaturmessorgan, beispielsweise in Form eines Pyrometers vorgesehen, so kann das vom Pyrometer gelieferte Mess-Signal einem Messwertmultiplexer zugeführt werden. Anhand der sensor-bestimmten Drehwinkelstellung des Substrathalter-Trägers kann der jeweilige Messwert einem Substrat zugeordnet werden. Diese Substrattemperaturen werden einem Temperaturregelorgan zugeleitet. Dieses ermittelt aus den Temperaturen einen Mittelwert. Der Mittelwert wird in Bezug gesetzt zu der Solltemperatur. Das Temperaturregelorgan liefert Ausgangssignale, die jedem Massenfluss-Steuergerät zugeführt werden, so dass jeder ein Gaspolster bildende Gasstrom individuell geregelt werden kann. Ingesamt erfolgt die Regelung so, dass eine minimale Substrathalterdrehzahl nicht unterschritten wird.

Ein Ausführungsbeispiel der Erfindung wird nachfolgend anhand beigefügter Zeichnungen erläutert. Es zeigen:
- Fig. 1: schematisch eine Draufsicht auf einen Substrathalter-Träger mit Drehzahlmessorganen,
- Fig. 2: einen Schnitt gemäß der Linie II-II einer Prozesskammer eines CVD-Reaktors,
- Fig. 3: in schematischer Darstellung die Mess- und Regelorgane und
- Fig. 4: grob schematisch den Temperatur/Zeitverlauf beim Aufheizen eines CVD-Reaktors und Einregeln der Substrattemperaturen.

Der CVD-Reaktor besitzt eine Prozesskammer, welche einen Boden besitzt, der von einem Substrathalter-Träger 1 gebildet wird. Die Prozesskammerdecke 10 ist vom Substrathalter-Träger 1 beabstandet und besitzt eine Öffnung 14, welche etwa auf Höhe der Zentren der satellitenartig auf dem Substrathalter-Träger 1 angeordneten Substrathalter 2 liegt.

Die Substrathalter 2 haben die Form von Kreiszylinderscheiben und liegen auf einem Gaspolster 8, welches dadurch gebildet wird, dass durch Strömungskanäle 6 jeder Aufnahmekammer eines Substrathalters 2 ein individueller Gasstrom zugeführt wird, welcher auf dem Boden der Aussparung durch Spiralnuten 7 derart austritt, dass die Substrathalter 2 drehangetrieben werden.

Auch der Substrathalter-Träger 1 ist drehangetrieben. Die Außenwandung des Substrathalter-Trägers 1 besitzt jedem Substrathalter 2 zugeordnete Fenster 5, durch welche ein Drehzahlmessorgan 4 optisch am Außenumfang des Substrathalters 2 angeordnete Index-Markierungen abtastet, um die Drehzahl der Substrathalter 2 zu bestimmen.

Jedem Substrathalter 2 ist eine individuelle Gasstromzuleitung zugeordnet, welche von einem individuellen Gasmassenflussregler MFC1 - MFC5 geregelt wird.

Oberhalb der Öffnung 14 befindet sich ein Temperaturmessorgan 3. Dieses kann ein Pyrometer sein. Die von dem Pyrometer 3 gelieferten Messwerte werden einem Messwertmultiplexer 12 zugeführt. Dieser erhält von einem in den Zeichnungen nicht dargestellten Drehwinkelgeber Informationen über den aktuellen Drehwinkel des Substrathalter-Trägers, so dass jeder von dem Temperaturmessorgan 3 ermittelten Temperatur T1 - T5 einem Substrathalter 2 bzw. dem darauf aufliegenden Substrat 9 zugeordnet werden kann.

Diese Substrat-Oberflächentemperaturen T1 - T5 werden einem Temperaturregelorgan 13 als Eingangsgrößen zur Verfügung gestellt. Eine weitere Eingangsgröße ist der Temperatursollwert Tsoll. Aus den Substrat-Oberflächentemperaturen T1 - T5 ermittelt das Temperaturregelorgan 13 einen Mittelwert und regelt diesen so, dass er dem Wert Tsoll entspricht. Dies erfolgt durch Ansteuerung der Hochfrequenz-Heizung HF.

Das Temperaturregelorgan 13 liefert zudem Steuerwerte für die einzelnen Gasmassenflussregler MFC1 - MFC5.

Die Größe der durch die Gasmassenflussregler fließenden Gasströme bestimmt die Höhe des Gaspolsters 8 und damit den Wärmetransport von der Hochfrequenz-Heizung durch den Substrathalter-Träger und den Substrathalter 2 zum Substrat 9. Je größer die Höhe des Gaspolsters 8 ist, desto weniger Wärme wird transportiert. Insofern lässt sich durch eine Variation des Gasmassenflusses die Oberflächentemperatur der Substrate 9 beeinflussen. Hierzu gibt das Temperaturregelorgan individuelle Ausgangssignale an die einzelnen Massenflussregler MFC1 - MFC5.

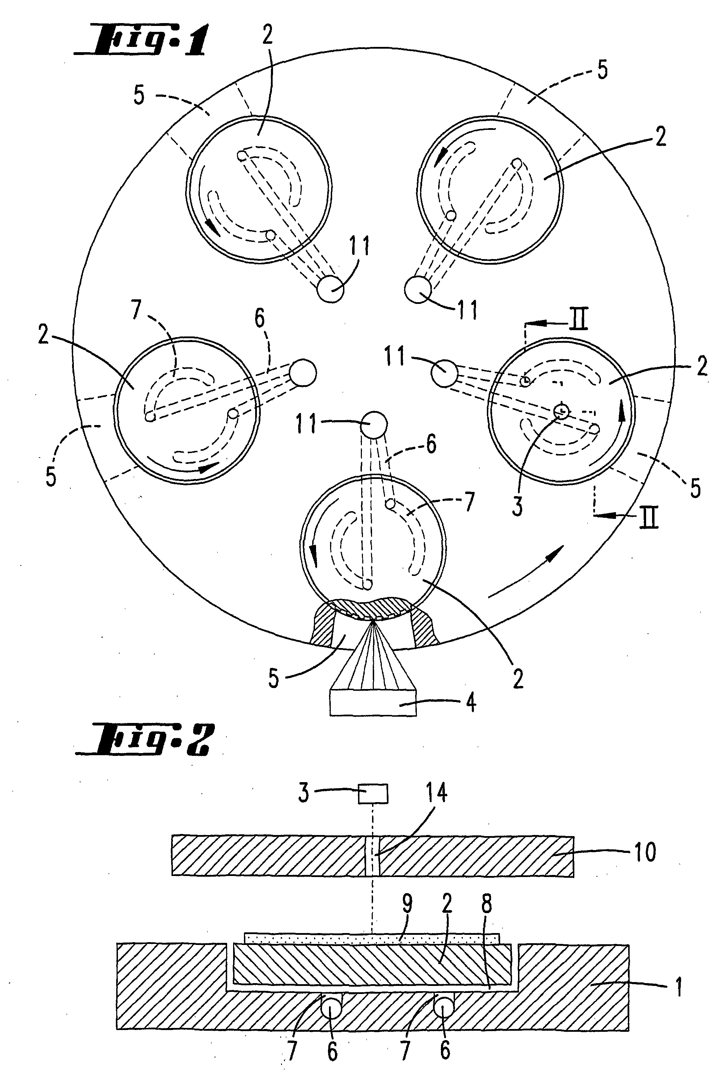

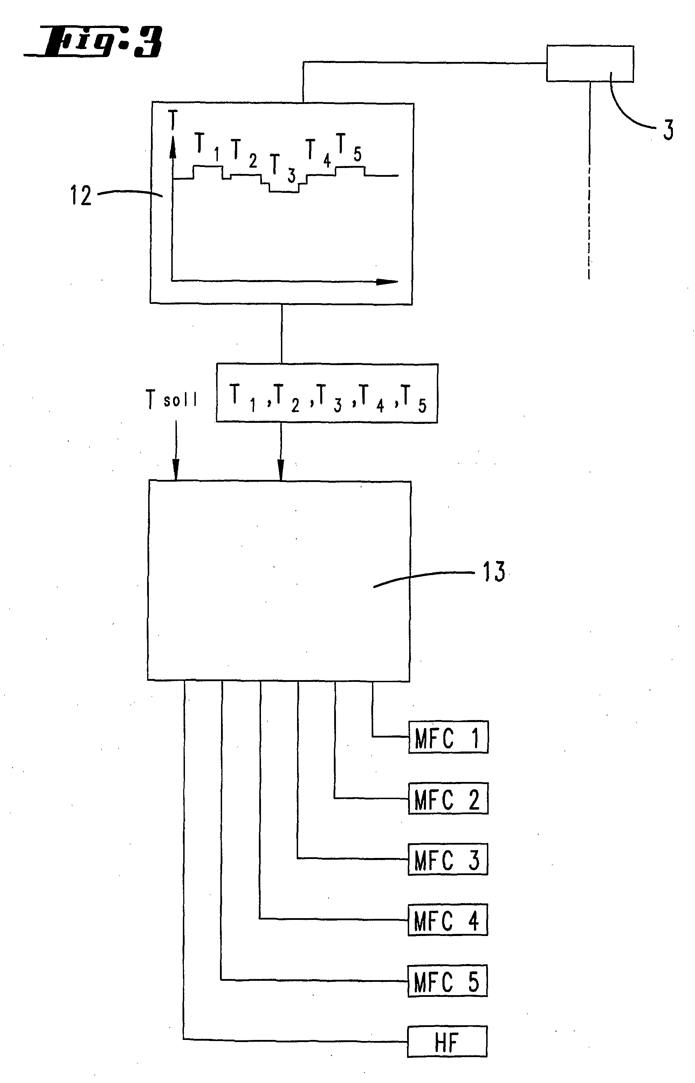

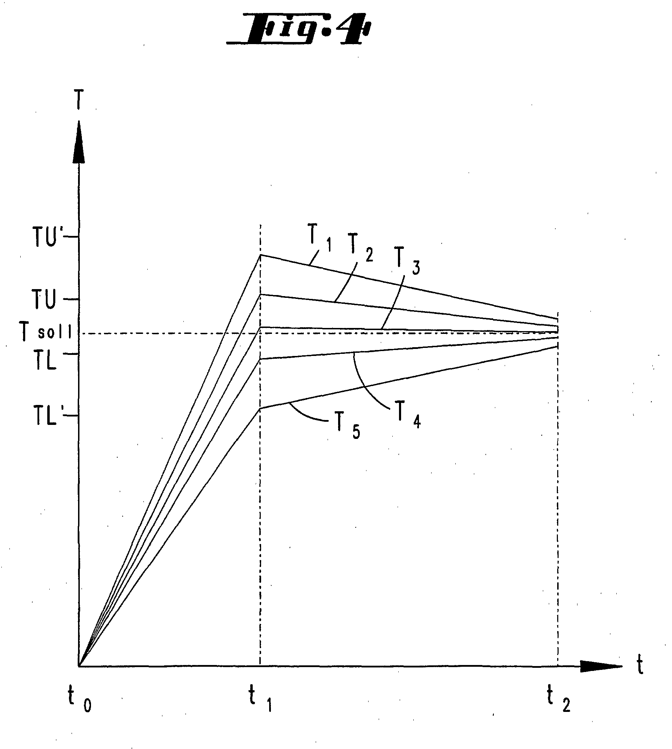

Wie in Fig. 4 dargestellt erfolgt das Aufheizen von t0 - t1 zunächst ohne eine Regelung der Gasmassenflüsse. Der Temperaturanstieg von der Temperatur t0 bis zur Temperatur t1 ist dort rein schematisch dargestellt. In der Realität verläuft die Rampe zum Ende hin flach. Dadurch stellen sich Anfangssubstrat-Oberflächentemperaturen T1 - T5 ein, die nach Erreichen des Sollwertes Tsoll zwischen einer oberen Grenztemperatur TU' und einer unteren Grenztemperatur TL' liegen. Zum Zeitpunkt t1 beginnt die Regelung. Dies hat zur Folge, dass die unterhalb der Temperatur Tsoll liegenden Temperaturen ansteigen und die oberhalb der Temperatur Tsoll liegenden Temperaturen absinken, bis die Substrattemperaturen T1 - T5 innerhalb eines durch die obere Temperatur TU und die untere Temperatur TL gebildeten Fensters liegen. Die Weite des Fensters entspricht etwa einem oder einem halben Grad. Wenn die Temperaturen T1 - T5 innerhalb des Fensters TU - TL liegen, ist der Zeitpunkt t2 erreicht, an dem der Beschichtungsprozess durch Einleitung der reaktiven Gase in bekannter Weise erfolgen kann.

Die Solltemperatur kann in einer Variante auch separat gemessen werden. Es ist insbesondere dabei vorgesehen, dass die Regelung der Hochfrequenzheizung zum Konstanthalten der Solltemperatur nur über den von diesem Messorgan gelieferten Messwert erfolgt.

In einer weiteren Variante ist vorgesehen, dass die Solltemperatur während des Prozesses geändert wird. Insbesondere für die Galliumnitrit-Technologie (vergleiche DE 197 34 034) kann es erforderlich sein, definierte Temperatur-Rampen zu durchfahren. Die Substrattemperatur steigt oder fällt dabei beispielsweise um 2 Grad pro Minute. Auch hier kann vorgesehen sein, dass die Hochfrequenzheizung über ein gesonderten Regelkreis über einen individuellen Messwertgeber zum Durchfahren der Rampe angesteuert wird. Mit den Gasmassenflussreglner wird dann nur die Abweichung der Substrattemperatur von der zeitlich variierenden Solltemperatur minimiert. Wird für eine Vielzahl für Substrate ein einzelnes Temperaturmessorgan verwendet, so nimmt dieses nicht kontinuierlich sonder intervallartig die Temperatur eines jeden Substrates auf. Die Differenztemperatur wird dann zu einem, dem jeweiligen Zeitpunkt entsprechenden, berechneten Sollwert bestimmt. Diese Differenztemperatur soll erfindungsgemäß möglichst klein gehalten werden. Zur Regelung kann ein entsprechendes Expertenssystem Verwendung finden.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Verfahren zur Temperatursteuerung der Oberflächentemperaturen von in einer Prozesskammer eines CVD-Reaktors auf von einem Substrathalter-Träger auf dynamischen Gaspolstern getragenen Substrathaltern liegenden Substraten, **dadurch gekennzeichnet, dass** von den insbesondere optisch gemessenen Oberflächentemperaturen (T1 - T5) Mittelwerte gebildet werden und durch Variation der einzelgesteuerten, die Gaspolster (8) erzeugenden Gasströme die Höhen der Gaspolster (8) so eingeregelt werden, dass die Abweichungen der gemessenen Oberflächentemperaturen (T1 - T5) vom Mittelwert innerhalb eines vorgegebenen Temperaturfensters (TU, TL) liegen.

2. Verfahren nach Anspruch 1 oder insbesondere danach, **dadurch gekennzeichnet, dass** der Mittelwert dem Substrattemperatursollwert (Tsoll) entspricht.

3. Verfahren nach einem oder mehreren der vorhergehenden Ansprüche oder insbesondere danach, **dadurch gekennzeichnet, dass** die Substrathalter (2) vom Gasstrom drehangetrieben werden.

4. Verfahren nach einem oder mehreren der vorhergehenden Ansprüche oder insbesondere danach, **dadurch gekennzeichnet, dass** die Drehzahl der Substrathalter (2) einen Minimalwert nicht unterschreitet.

5. Verfahren nach einem oder mehreren der vorhergehenden Ansprüche oder insbesondere danach, **dadurch gekennzeichnet, dass** die Temperaturmessung durch eine Öffnung (14) einer Prozesskammerdecke (10) erfolgt.

6. Verfahren nach einem oder mehreren der vorhergehenden Ansprüche oder insbesondere danach, **dadurch gekennzeichnet, dass** der Substrathalter-Träger (1) drehangetrieben wird und von einem Temperaturmessorgan (3) die Oberflächentemperaturen der nacheinander sich an dem Temperaturmessorgan (3) vorbeibewegenden Substrate (9) gemessen werden.

7. Verfahren nach einem oder mehreren der vorhergehenden Ansprüche oder insbesondere danach, **dadurch gekennzeichnet, dass** das Aufheizen der Prozesskammer mit ungeregelten Gasströmen erfolgt und die Regelung erst dann beginnt, wenn der Mittelwert einen insbesondere stabilen Sollwert erreicht hat.

8. Verfahren nach einem oder mehreren der vorhergehenden Ansprüche oder insbesondere danach, **dadurch gekennzeichnet, dass** die Solltemperatur stetig ansteigend oder stetig abfallend entlang einer Rampe geregelt wird und die Oberflächentemperaturen (T1 - T5) dynamisch dieser Solltemperatur nachgeregelt werden.

9. CVD-Reaktor mit einer Vielzahl auf einem Substrathalter-Träger auf dynamischen Gaspolstern getragenen Substrathaltern, **gekennzeichnet durch** eine mindestens ein Temperaturmessorgan (3) aufweisende Messvorrichtung zum Bestimmen der Oberflächentemperaturen (T1 - T5) aller auf den Substrathaltern aufliegenden Substraten (9), ein Temperaturregelorgan (13) und jedem Substrathalter (2) individuell zugeordnete Gasmassensteuereinrichtungen (MFC1 - MFC5), welche vom Temperaturregelorgan (13) derart angesteuert werden, dass **durch** Variation der Gaspolsterhöhe die Substrattemperaturen (T1 - T5) in einem vorgegebenen Temperaturfenster (TU, TUL) gehalten werden.

10. CVD-Reaktor nach einem oder mehreren der vorhergehenden Ansprüche oder insbesondere danach, **gekennzeichnet durch** vom Gasstrom drehangetriebene Substrathalter (2).

11. CVD-Reaktor nach einem oder mehreren der vorhergehenden Ansprüche oder insbesondere danach, **gekennzeichnet durch** einen drehangetriebenen Substrathalter-Träger (1).

12. CVD-Reaktor nach einem oder mehreren der vorhergehenden Ansprüche oder insbesondere danach, **gekennzeichnet durch** ein einziges oberhalb einer Öffnung (14) der Prozesskammerdecke (10) angeordnetes Temperaturmessorgan (3).

13. CVD-Reaktor nach einem oder mehreren der vorhergehenden Ansprüche oder insbesondere danach, **gekennzeichnet durch** ein am Außenumfang des Substrathalter-Trägers (2) vorgesehenes Drehzahlmessorgan (4), welches optisch **durch** Fenster (5) des Substrathalter-Trägers (3) mit Index-Markierungen versehene Umfangsflächen der Substrathalter (2) abtastet.

14. CVD-Reaktor nach einem oder mehreren der vorhergehenden Ansprüche oder insbesondere danach, **gekennzeichnet durch** ein dem einzigen Temperaturmessorgan (3) zugeordneten Messwertmultiplexer (12).

## Claims

1. Method for the temperature control of the surface temperatures of substrates which are located in a process chamber of a CVD reactor on substrate holders carried on dynamic gas cushions by a substrate holder carrier, **characterized in that** mean values are formed from the surface temperatures (T1-T5) which are measured in particular optically, and the heights of the gas cushions (8) are adjusted in such a way, through variation of the individually controlled gas streams which generate the gas cushions (8), that the deviations of the measured surface temperatures (T1-T5) from the mean value lie within a predetermined temperature window (TU, TL).

2. Method according to Claim 1 or in particular according thereto, **characterized in that** the mean value corresponds to the substrate temperature desired value (Tdes).

3. Method according to one or more of the preceding claims or in particular according thereto, **characterized in that** the substrate holders (2) are driven in rotation by the gas stream.

4. Method according to one or more of the preceding claims or in particular according thereto, **characterized in that** the rotational speed of the substrate holders (2) does not fall below a minimum value.

5. Method according to one or more of the preceding claims or in particular according thereto, **characterized in that** the temperature measurement is carried out through an opening (14) in a process chamber cover (10).

6. Method according to one or more of the preceding claims or in particular according thereto, **characterized in that** the substrate holder carrier (1) is driven in rotation, and the surface temperatures of the substrates (9) which successively move past a temperature-measuring element (3) are measured by the temperature-measuring element (3).

7. Method according to one or more of the preceding claims or in particular according thereto, **characterized in that** the process chamber is heated up by uncontrolled gas streams, and the control only commences when the mean value has reached an in particular stable desired value.

8. Method according to one or more of the preceding claims or in particular according thereto, **characterized in that** the desired temperature is controlled so as to rise or fall continuously along a ramp, and the surface temperatures (T1-T5) are made to dynamically track this desired temperature.

9. CVD reactor having a multiplicity of substrate holders carried on dynamic gas cushions on a substrate holder carrier, **characterized by** a measuring device, which has at least one temperature-measuring element (3), for determining the surface temperatures (T1-T5) of all the substrates (9) located on the substrate holders, a temperature-control element (13) and gas mass flow control means (MFC1-MFC5) which are individually associated with each substrate holder (2) and are actuated by the temperature-control element (13) in such a manner that the substrate temperatures (T1-T5) are kept within a predetermined temperature window (TU, TUL) by variation of the gas cushion height.

10. CVD reactor according to one or more of the preceding claims or in particular according thereto, **characterized by** substrate holders (2) which are driven in rotation by the gas stream.

11. CVD reactor according to one or more of the preceding claims or in particular according thereto, **characterized by** a substrate holder carrier (1) which is driven in rotation.

12. CVD reactor according to one or more of the preceding claims or in particular according thereto, **characterized by** a single temperature-measuring element (3) disposed above an opening (14) in the process chamber cover (10).

13. CVD reactor according to one or more of the preceding claims or in particular according thereto, **characterized by** a rotational speed-measuring element (4) which is provided at the outer periphery of the substrate holder carrier (2) and, through windows (5) in the substrate holder carrier (3), optically scans peripheral surfaces, which are provided with index marks, of the substrate holders (2).

14. CVD reactor according to one or more of the preceding claims or in particular according thereto, **characterized by** a measured-value multiplexer (12) which is associated with the single temperature-measuring element (3).

## Revendications

1. Procédé de commande de températures de surface de substrats se trouvant dans une chambre de traitement d'un réacteur CVD sur des porte-substrats supportés par un support de porte-substrat sur coussins de gaz dynamiques, **caractérisé en ce que** des valeurs moyennes sont calculées à partir des températures de surface (T1 à T5) mesurées en particulier par des moyens optiques et, en faisant varier les flux de gaz commandés individuellement et générant les coussins de gaz (8), on régule la hauteur des coussins de gaz (8) de sorte que les écarts entre les températures de surface mesurées (T1 à T5) et la valeur moyenne se trouvent à l'intérieur d'une fenêtre de température prédéterminée (TU, TL).

2. Procédé selon la revendication 1 ou en particulier selon celle-ci, **caractérisé en ce que** la valeur moyenne correspond à la valeur de consigne de température de substrat (Tsoll).

3. Procédé selon l'une ou plusieurs des revendications précédentes ou en particulier selon celles-ci, **caractérisé en ce que** les porte-substrats (2) sont entraînés en rotation par le flux de gaz.

4. Procédé selon l'une ou plusieurs des revendications précédentes ou en particulier selon celles-ci, **caractérisé en ce que** la vitesse de rotation des porte-substrats (2) n'est pas inférieure à une valeur minimale.

5. Procédé selon l'une ou plusieurs des revendications précédentes ou en particulier selon celles-ci, **caractérisé en ce que** la mesure de température est effectuée par une ouverture (14) d'un capot de chambre de traitement (10).

6. Procédé selon l'une ou plusieurs des revendications précédentes ou en particulier selon celles-ci, **caractérisé en ce que** le support de porte-substrat (1) est entraîné en rotation et **en ce qu'**un organe de mesure de température (3) mesure les températures de surface des substrats (9) passant l'un après l'autre devant l'organe de mesure de température (3).

7. Procédé selon l'une ou plusieurs des revendications précédentes ou en particulier selon celles-ci, **caractérisé en ce que** le chauffage de la chambre de traitement est effectué avec des flux de gaz non régulés et la régulation n'est commencée que lorsque la valeur moyenne a atteint une valeur de consigne, en particulier stable.

8. Procédé selon l'une ou plusieurs des revendications précédentes ou en particulier selon celles-ci, **caractérisé en ce que** la température de consigne est régulée pour augmenter ou diminuer de façon constante le long d'une rampe et **en ce que** les températures de surface (T1 à T5) sont réajustées dynamiquement conformément à cette température de consigne.

9. Réacteur CVD comportant un grand nombre de porte-substrats supportés par un support de porte-substrats sur des coussins de gaz dynamiques, **caractérisé par** un dispositif de mesure comportant au moins un organe de mesure de température (3) pour déterminer les températures de surface (T1 à T5) de tous les substrats (9) placés sur les porte-substrats, un organe de régulation de température (13) et des dispositifs de commande de masse de gaz (MFC1 à MFC5) qui sont associés individuellement à chaque porte-substrat (2) et qui sont commandés par le dispositif de régulation de température (13) de telle sorte que, en faisant varier la hauteur des coussins de gaz, les températures de substrat (T1 à T5) sont maintenues dans une fenêtre de température prédéterminée (TU, TUL).

10. Réacteur CVD selon l'une ou plusieurs des revendications précédentes ou en particulier selon celles-ci, **caractérisé par** des porte-substrats (2) entraînés en rotation par le flux de gaz.

11. Réacteur CVD selon l'une ou plusieurs des revendications précédentes ou en particulier selon celles-ci, **caractérisé par** un support (1) de porte-substrats entraîné en rotation.

12. Réacteur CVD selon l'une ou plusieurs des revendications précédentes ou en particulier selon celles-ci, **caractérisé par** un unique organe de mesure de température (3) placé au-dessus d'une ouverture (14) du capot de chambre de traitement (10).

13. Réacteur CVD selon l'une ou plusieurs des revendications précédentes ou en particulier selon celles-ci, **caractérisé par** un organe de mesure de tours de rotation (4) qui est prévu à la périphérie extérieure du support de porte-substrats (2) et qui balaie par des moyens optiques à travers des fenêtres (5) du support de porte-substrat (3) des surfaces périphériques, dotées de repères d'index, des porte-substrats (2).

14. Réacteur CVD selon l'une ou plusieurs des revendications précédentes ou en particulier selon celles-ci, **caractérisé par** un multiplexeur de valeurs de mesure (12) associé à l'unique organe de mesure de température (3).
